# EUROPEAN PATENT APPLICATION

(11) **EP 2 983 198 A1**
(43) Date of publication of application: **10.02.2016**
(21) Application number: 14778263.5
(22) Date of filing: 07.02.2014
(51) Int. Cl.: H01L 21/66, H01L 21/336, H01L 29/12, H01L 29/78

(54) **METHOD FOR MANUFACTURING SILICON CARBIDE SEMICONDUCTOR DEVICE**

(30) Priority: 01.04.2013 JP 2013075747
(71) Applicant: Sumitomo Electric Industries, Ltd., Osaka-shi, Osaka 541-0041 (JP)
(72) Inventor: YAMADA, Satomi, Osaka-shi Osaka 554-0024 (JP); TSUNO, Takashi, Osaka-shi Osaka 554-0024 (JP)
(74) Representative: Grünecker Patent- und Rechtsanwälte PartG mbB
(86) International application number: PCT/JP2014/052861
(87) International publication number: WO 2014/162775

(57) **Abstract**

A method for manufacturing a silicon carbide semiconductor device (1) includes the steps of preparing a silicon carbide substrate (80) having a first main surface (80b) and a second main surface (80a) opposite to the first main surface (80b), causing etch pits (3a) including micropipes to appear in the first main surface (80b) by etching the first main surface (80b), obtaining two-dimensional positional information on the micropipes in the first main surface (80b); cutting the silicon carbide substrate into a plurality of chips (C12 to C65); and performing screening of the chips (C12 to C65) based on the two-dimensional positional information, wherein the first main surface (80b) is a silicon plane or a plane having an off angle of less than or equal to 10° relative to the silicon plane. Thereby, a method for manufacturing a silicon carbide semiconductor device by which chips including micropipes can be screened out with high accuracy can be provided.

## Description

### TECHNICAL FIELD

The present invention relates to a method for manufacturing a silicon carbide semiconductor device, and in particular to a method for manufacturing a silicon carbide semiconductor device including the step of performing screening of chips.

### BACKGROUND ART

In recent years, in order to achieve high breakdown voltage, low loss, and utilization of semiconductor devices under a high temperature environment, silicon carbide has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

Among defects that may occur in silicon carbide substrates, micropipes are problematic in particular. For example, "Reliability consideration for recent Infineon SiC diode releases" by M. Holz and three others, Microelectronics Reliability, No. 47, August 21, 2007, pp 1741 to 1745 (NPD 1) describes a method for detecting micropipes. According to the document, micropipes are detected by applying an avalanche breakdown voltage to a device and checking a change in leakage current before and after the application of the voltage.

### CITATION LIST

### NON PATENT DOCUMENT

NPD 1: "Reliability consideration for recent Infineon SiC diode releases" by M. Holz and three others, Microelectronics Reliability, No. 47, August 21, 2007, pp. 1741 to 1745

### SUMMARY OF INVENTION

### TECHNICAL PROBLEM

When an epitaxial layer is formed on a silicon carbide substrate having micropipes, the micropipes are blocked by the epitaxial layer In the present specification, a micropipe blocked by an epitaxial layer is called a blocked micropipe. In the stage of an ordinary inspection before shipment, a device having a blocked micropipe exhibits characteristics not inferior to those of a device having no blocked micropipe. However, the device having a blocked micropipe may have an increased leakage current after being used for two or three months, and thus it is desirable to screen out such a device by the inspection before shipment.

In the method described in the above document, however, when a micropipe is present in a guard ring termination portion, no current flows through the guard ring termination portion even if an avalanche breakdown voltage is applied to a device, and thus there is no increase in leakage current based on the comparison between before and after the application of the voltage. Accordingly, when a micropipe is present in a guard ring portion, the micropipe cannot be detected by the method described in the above document, and thus the accuracy of detecting micropipes is not sufficient. As a result, there may be cases where chips including micropipes are shipped without being screened out.

The present invention has been made to solve such a problem, and an object of the present invention is to provide a method for manufacturing a silicon carbide semiconductor device by which chips including micropipes can be screened out with high accuracy

### SOLUTION TO PROBLEM

A method for manufacturing a silicon carbide semiconductor device in accordance with the present invention includes the steps of preparing a silicon carbide substrate having a first main surface and a second main surface opposite to the first main surface; causing etch pits including micropipes to appear in the first main surface by etching the first main surface; obtaining two-dimensional positional information on the micropipes in the first main surface; cutting the silicon carbide substrate into a plurality of chips, and performing screening of the chips based on the two-dimensional positional information, wherein the first main surface is a silicon plane or a plane having an off angle of less than or equal to 10° relative to the silicon plane

### ADVANTAGEOUS EFFECTS OF INVENTION

As is clear from the above description, the present invention can provide a method for manufacturing a silicon carbide semiconductor device by which chips including micropipes can be screened out with high accuracy.

### BRIEF DESCRIPTION OF DRAWINGS

Fig. 1 is a schematic cross sectional view schematically showing a structure of a silicon carbide semiconductor device in a first embodiment of the present invention.
Fig 2 is a schematic perspective view schematically showing a shape of a silicon carbide substrate of the silicon carbide semiconductor device in the first embodiment of the present invention.
Fig. 3 is a flowchart schematically showing a method for manufacturing the silicon carbide semiconductor device in the first embodiment of the present invention.
Fig. 4 is a flowchart schematically showing a method for manufacturing a silicon carbide semiconductor device in a second embodiment of the present invention
Fig. 5 is a schematic cross sectional view schematically showing a first step of the method for manufacturing the silicon carbide semiconductor device in the first embodiment of the present invention.
Fig. 6 is a schematic cross sectional view schematically showing a second step of the method for manufacturing the silicon carbide semiconductor device in the first embodiment of the present invention.
Fig. 7 is a schematic cross sectional view schematically showing a fourth step of the method for manufacturing the silicon carbide semiconductor device in the first embodiment of the present invention.
Fig 8 is a schematic cross sectional view schematically showing a fifth step of the method for manufacturing the silicon carbide semiconductor device in the first embodiment of the present invention.
Fig. 9 is a schematic cross sectional view schematically showing a sixth step of the method for manufacturing the silicon carbide semiconductor device in the first embodiment of the present invention.
Fig. 10 is a schematic cross sectional view schematically showing a seventh step of the method for manufacturing the silicon carbide semiconductor device in the first embodiment of the present invention.
Fig. 11 is a schematic cross sectional view schematically showing an eighth step of the method for manufacturing the silicon carbide semiconductor device in the first embodiment of the present invention.
Fig. 12 is a schematic cross sectional view schematically showing a ninth step of the method for manufacturing the silicon carbide semiconductor device in the first embodiment of the present invention.
Fig 13 is a schematic cross sectional view schematically showing a tenth step of the method for manufacturing the silicon carbide semiconductor device in the first embodiment of the present invention.
Fig. 14 is a schematic cross sectional view schematically showing an eleventh step of the method for manufacturing the silicon carbide semiconductor device in the first embodiment of the present invention
Fig. 15 is a schematic cross sectional view schematically showing a twelfth step of the method for manufacturing the silicon carbide semiconductor device in the first embodiment of the present invention.
Fig. 16 is a schematic cross sectional view schematically showing a thirteenth step of the method for manufacturing the silicon carbide semiconductor device in the first embodiment of the present invention.
Fig 17 is a schematic cross sectional view schematically showing a fourteenth step of the method for manufacturing the silicon carbide semiconductor device in the first embodiment of the present invention.
Fig. 18 is a schematic cross sectional view schematically showing a fifteenth step of the method for manufacturing the silicon carbide semiconductor device in the first embodiment of the present invention.
Fig. 19 is a schematic cross sectional view schematically showing a sixteenth step of the method for manufacturing the silicon carbide semiconductor device in the first embodiment of the present invention.
Fig. 20 is a schematic plan view schematically showing a third step of the method for manufacturing the silicon carbide semiconductor device in the first embodiment of the present invention.
Fig. 21 is a schematic plan view schematically showing a seventeenth step of the method for manufacturing the silicon carbide semiconductor device in the first embodiment of the present invention.
Fig 22 is a schematic plan view schematically showing the step of forming a cutting position pattern in the method for manufacturing the silicon carbide semiconductor device in the second embodiment of the present invention.

### DESCRIPTION OF EMBODIMENTS

Hereinafter, embodiments of the present invention will be described with reference to the drawings. It should be noted that, in the below-mentioned drawings, the same or corresponding portions are given the same reference characters and are not described repeatedly. Further, in the crystallographic description in the present specification, an individual orientation is represented by [], a group orientation is represented by <>, an individual plane is represented by (), and a group plane is represented by {}. In addition, a negative crystallographic index is normally expressed by putting "-" (bar) above a numeral, but is expressed by putting the negative sign before the numeral in the present specification.

First, an overview of the embodiments of the present invention will be described in (1) to (8) below.
(1) A method for manufacturing a silicon carbide semiconductor device 1 in accordance with the present embodiment includes the steps of: preparing a silicon carbide substrate 80 having a first main surface 80b and a second main surface 80a opposite to first main surface 80b; causing etch pits 3a including micropipes to appear in first main surface 80b by etching first main surface 80b; obtaining two-dimensional positional information on the micropipes in first main surface 80b, cutting the silicon carbide substrate into a plurality of chips C12 to C65; and performing screening of chips C12 to C65 based on the two-dimensional positional information, wherein first main surface 80b is a silicon plane or a plane having an off angle of less than or equal to 10° relative to the silicon plane.
   According to silicon carbide semiconductor device 1 in accordance with the present embodiment, the two-dimensional positional information on the micropipes in first main surface 80b is obtained, and screening of the chips is performed based on the two-dimensional positional information. Accordingly, no matter where a micropipe is present in first main surface 80b of silicon carbide substrate 80, a chip including the micropipe can be detected. As a result, chips including micropipes can be screened out with high accuracy.
(2) Preferably, in the method for manufacturing silicon carbide semiconductor device 1 in accordance with the present embodiment, a silicon carbide epitaxial layer 81 is formed in contact with second main surface 80a. Thereby, even if a micropipe is covered with silicon carbide epitaxial layer 81 and becomes a blocked micropipe, a chip including the micropipe can be screened out with high accuracy
(3) Preferably, in the method for manufacturing silicon carbide semiconductor device 1 in accordance with the present embodiment, a pattern 2 indicating a cutting position for chips C12 to C65 is formed on a front surface 10a of silicon carbide epitaxial layer 81. In the step of cutting silicon carbide substrate 80 into the plurality of chips C12 to C65, silicon carbide substrate 80 is cut along pattern 2. By forming the pattern indicating the cutting position, a chip in which a micropipe is present can be specified by a simple method.
(4) Preferably, in the method for manufacturing silicon carbide semiconductor device 1 in accordance with the present embodiment, the step of performing screening of chips C12 to C65 is performed by comparing the two-dimensional positional information on the micropipes with a position of pattern 2. In a case where silicon carbide substrate 80 has small warpage, a chip in which a micropipe is present can be specified by a simple method and with high accuracy, by comparing the two-dimensional positional information on the micropipes in first main surface 80b with the position of pattern 2 formed on front surface 10a, which is on a side closer to second main surface 80a
(5) Preferably, in the method for manufacturing silicon carbide semiconductor device 1 in accordance with the present embodiment, the two-dimensional positional information is associated with identification numbers of chips C12 to C65. Thereby, a chip in which a micropipe is present can be specified.
(6) Preferably, in the method for manufacturing silicon carbide semiconductor device 1 in accordance with the present embodiment, first main surface 80b is polished after the step of causing etch pits 3 including the micropipes to appear. Thereby, warpage of silicon carbide substrate 80 generated in the step of causing the etch pits to appear can be reduced. Further, when first main surface 80b is polished after the step of forming silicon carbide epitaxial layer 81 in contact with second main surface 80a, both warpage of silicon carbide substrate 80 generated by the step of forming silicon carbide epitaxial layer 81 and warpage of silicon carbide substrate 80 generated in the step of causing the etch pits to appear can be reduced.
(7) Preferably, in the method for manufacturing silicon carbide semiconductor device 1 in accordance with the present embodiment, first main surface 80b is ground to remove at least portions of etch pits 3 By removing small etch pits 3b other than etch pits 3a of micropipes, defects in a conforming chip can be removed. Further, when etch pits 3a of micropipes are also removed, first main surface 80b has small unevenness. Thus, planarization of an electrode 98 formed in contact with first main surface 80b can be improved.
(8) Preferably, in the method for manufacturing silicon carbide semiconductor device 1 in accordance with the present embodiment, electrode 98 is formed in contact with first main surface 80b after the step of grinding first main surface 80b. Thereby, adhesion of electrode 98 to first main surface 80b can be improved.

Next, the embodiments of the present invention will be described in more detail.

### (First Embodiment)

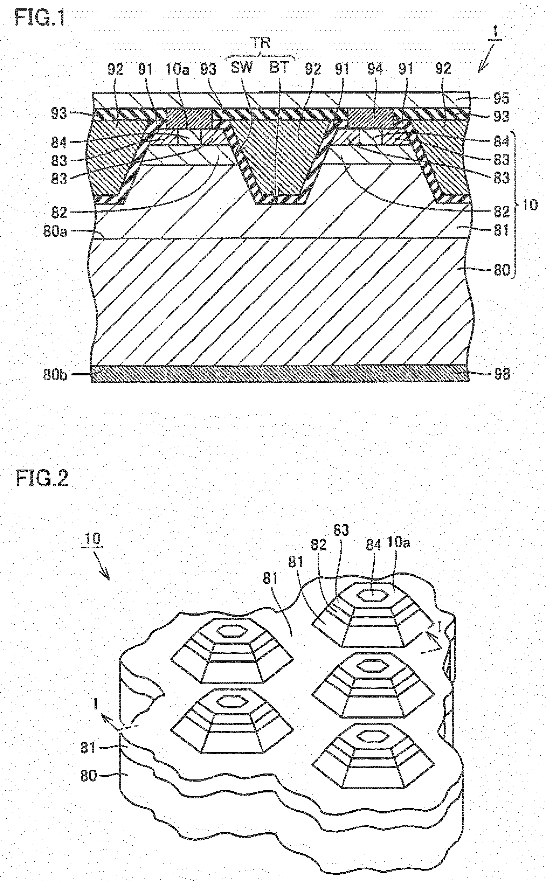

Referring to Figs. 1 and 2, a structure of an MOSFET 1 as a silicon carbide semiconductor device in accordance with the present embodiment will be described.

MOSFET 1 of the present embodiment mainly has a silicon carbide substrate 10, a gate insulating film 91, a gate electrode 92, an interlayer insulating film 93, a source electrode 94, a source interconnection layer 95, and drain electrode 98 (back surface electrode). Silicon carbide substrate 10 has, for example, silicon carbide substrate 80, an n type drift region 81 (epitaxial layer), a p type base region 82, an n type region 83, and a p type contact region 84.

Silicon carbide substrate 80 is made of, for example, hexagonal silicon carbide, and has a polytype of 4H. Silicon carbide substrate 80 has, for example, n type (a first conductivity type) N type drift region 81 is an epitaxial layer formed on silicon carbide substrate 80 N type drift region 81 has n type. Preferably, the impurity concentration in n type drift region 81 is lower than the impurity concentration in silicon carbide substrate 80 The donor concentration in n type drift region 81 is preferably more than or equal to 1×10¹⁵ cm⁻³ and less than or equal to 5×10¹⁶ cm⁻³, and is 8×10¹⁵ cm⁻³, for example.

P type base region 82 has p type (a second conductivity type). P type base region 82 is provided on n type drift region 81. The impurity concentration in p type base region 82 is 1×10¹⁸ cm⁻³, for example. N type region 83 has n type. N type region 83 is provided on p type base region 82 to be separated from n type drift region 81 by p type base region 82. P type contact region 84 has p type. P type contact region 84 is connected to source electrode 94 and p type base region 82.

A trench TR is provided in front surface 10a of silicon carbide substrate 10. Trench TR has a wall surface SW and a bottom portion BT. Wall surface SW penetrates n type region 83 and p type base region 82, and reaches n type drift region 81. On p type base region 82, wall surface SW includes a channel surface of MOSFET 1.

Wall surface SW is inclined with respect to front surface 10a of silicon carbide substrate 10, and trench TR spreads in a tapered manner toward an opening. Preferably, the plane orientation of wall surface SW is inclined with respect to a (000-1) plane by more than or equal to 50° and less than or equal to 65°. Bottom portion BT is located on n type drift region 81. In the present embodiment, bottom portion BT is a surface which is substantially parallel to front surface 10a of silicon carbide substrate 10.

Gate insulating film 91 covers each of wall surface SW and bottom portion BT of trench TR. Gate electrode 92 is provided on gate insulating film 91 Source electrode 94 is in contact with each of n type region 83 and p type contact region 84. Source interconnection layer 95 is in contact with source electrode 94. Source interconnection layer 95 is an aluminum layer, for example. Interlayer insulating film 93 insulates gate electrode 92 from source interconnection layer 95. Drain electrode 98 (back surface electrode) is arranged in contact with silicon carbide substrate 80.

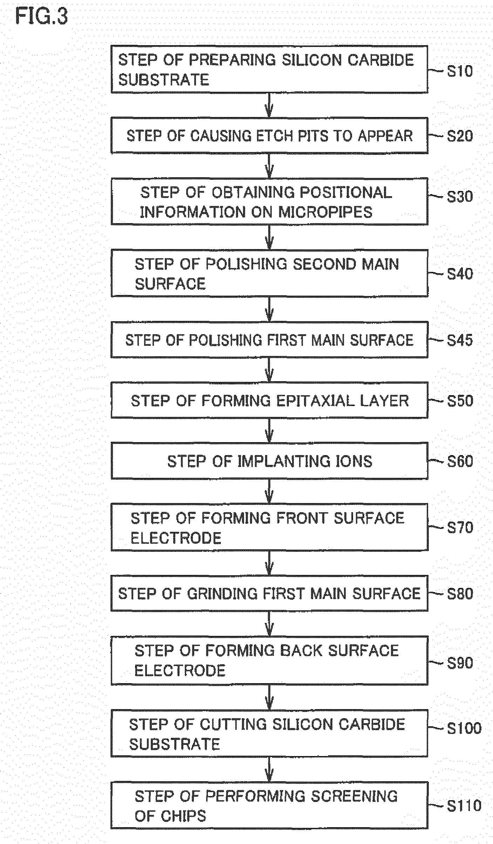

Next, a method for manufacturing MOSFET 1 in accordance with the first embodiment will be described with reference to Fig. 3.

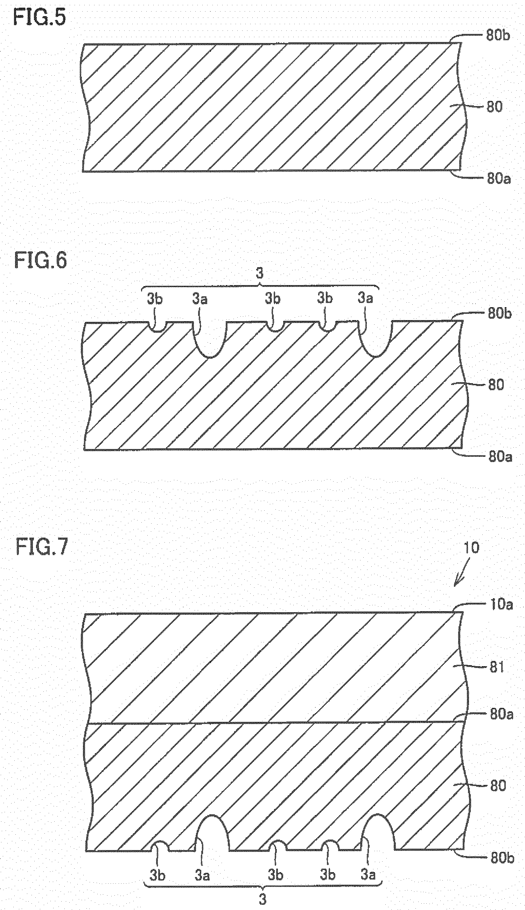

First, the step of preparing a silicon carbide substrate (S10: Fig. 3) is performed. Silicon carbide substrate 80 (Fig. 5) having n type conductivity type (the first conductivity type), and having first main surface 80b and second main surface 80a on an opposite side is prepared by slicing an ingot made of, for example, hexagonal silicon carbide having a polytype of 4H formed by a sublimation method. It should be noted that first main surface 80b is a silicon plane or a plane having an off angle of less than or equal to 10° relative to the silicon plane, and second main surface 80a is a carbon plane or a plane having an off angle of less than or equal to 10° relative to the carbon plane.

Next, the step of causing etch pits to appear (S20: Fig. 3) is performed. In the step of causing etch pits to appear, etch pits 3 including etch pits 3a of micropipes appear in first main surface 80b of silicon carbide substrate 80, by etching first main surface 80b. Referring to Fig. 6, etch pits 3 are formed as a result of spreading, by etching, of crystal defects such as screw dislocations (threading screw dislocations), edge dislocations (threading edge dislocations), composite dislocations, basal plane dislocations, and micropipes. That is, etch pits 3 include etch pits 3a of micropipes and etch pits 3b due to defects other than micropipes Etch pits 3b due to defects other than micropipes include, for example, etch pits of screw dislocations (threading screw dislocations), etch pits of edge dislocations (threading edge dislocations), etch pits of composite dislocations (threading composite dislocations), etch pits of basal plane dislocations, and the like.

The etching for causing the above etch pits to appear may be dry etching or wet etching. As the dry etching, for example, gas etching may be used. For the gas etching, nitrogen gas, chlorine gas, and oxygen gas may be used. Specifically, for example, silicon carbide substrate 80 having first main surface 80b is placed within a chamber, nitrogen is introduced into the chamber, and the pressure is set to 50 Pa and the temperature is set to 1050°C within the chamber. Next, for example, chlorine gas is caused to flow through the chamber at a flow velocity of 0.2 slm for 45 minutes. Next, for example, a mixed gas of nitrogen and oxygen (nitrogen: 90%, oxygen: 10%) is caused to flow through the chamber at a flow velocity of 3 slm for five minutes. It should be noted that, after the chlorine gas is introduced into the chamber, the pressure within the chamber increases to 90000 Pa. When the mixed gas of nitrogen and oxygen is introduced, the pressure within the chamber is 50000 Pa, and thereafter increases to 90000 Pa. In addition, as the wet etching, KOH (potassium hydroxide) etching may be performed. Specifically, silicon carbide substrate 10 having first main surface 80b is immersed, for example, in molten KOH at 515°C, for eight minutes. Next, silicon carbide substrate 10 having first main surface 80b is washed with pure water. Hence, etch pits 3a of micropipes and etch pits 3b other than micropipes appear in first main surface 80b.

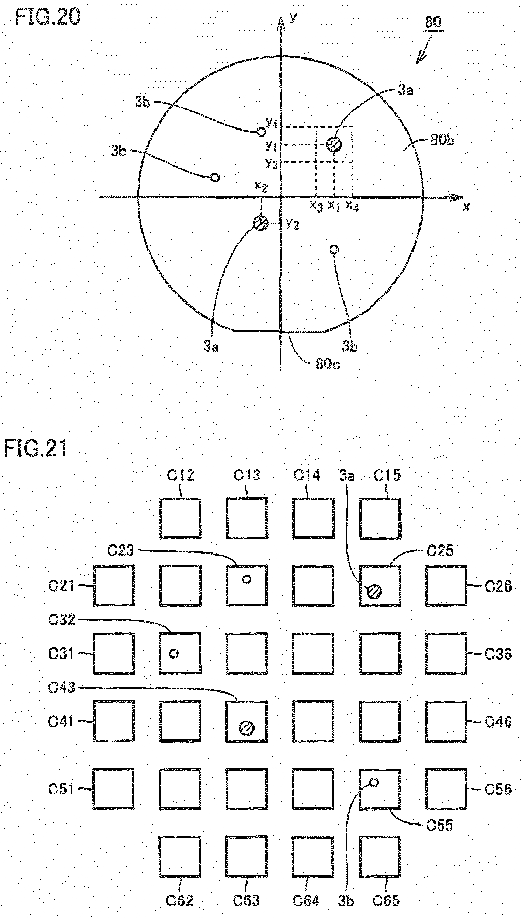

Next, the step of obtaining positional information on the micropipes (S30: Fig. 3) is performed. In the step of obtaining positional information on the micropipes, two-dimensional positional information on etch pits 3a of micropipes in first main surface 80b of silicon carbide substrate 80 is obtained. Specifically, referring to Fig. 20, etch pits 3a of micropipes which have appeared in first main surface 80b of silicon carbide substrate 80 are optically observed using, for example, an optical microscope or the like. Observation of etch pits 3a of micropipes may be performed by placing the optical microscope on the first main surface 80b side of silicon carbide substrate 80 and observing first main surface 80b from the first main surface 80b side, or may be performed by placing the optical microscope on the second main surface 80a side of silicon carbide substrate 80 and observing first main surface 80b from the second main surface 80a side through silicon carbide substrate 10.

By analyzing an image observed by the optical microscope, two-dimensional positions of etch pits 3a of micropipes in first main surface 80b of silicon carbide substrate 80 are specified. Preferably, an image of entire first main surface 80b is obtained by the optical microscope, and two-dimensional positions of all etch pits 3a of micropipes present in first main surface 80b are specified. For example, a line which is parallel to an orientation flat 80c of silicon carbide substrate 80 and is located in first main surface 80b is defined as the x axis, and a line which is perpendicular to the x axis and is located in first main surface 80b is defined as the y axis. For example, in a case where the x axis is arranged at a position where first main surface 80b has a maximum width in the x axis direction and the y axis is arranged at a position where first main surface 80b has a maximum width in the y axis direction, the position where the x axis and the y axis intersect with each other is defined as the origin of coordinates (that is, x=0, y=0). Two-dimensional positional information on a micropipe in first main surface 80b is, for example, coordinates of a position of the center of etch pit 3a of the micropipe when first main surface 80b is considered as an xy coordinate system (for example, x=x₁, y=y₁). The two-dimensional positional information on the micropipes may be temporarily saved in a memory. In addition, whether an etch pit is etch pit 3a of a micropipe or etch pit 3b other than etch pit 3a of a micropipe may be determined, for example, as described below. For example, an etch pit of a size larger than a certain size may be determined as etch pit 3a of a micropipe. Alternatively, an etch pit larger than other etch pits 3b when compared with other etch pits 3b may be determined as etch pit 3a of a micropipe.

Next, the step of polishing the second main surface (S40 Fig, 3) is performed. Specifically, for example by chemical mechanical polishing using an abrasive material such as colloidal silica, second main surface 80a of silicon carbide substrate 80 is polished, and second main surface 80a is planarized to the extent that allows epitaxial growth.

Next, the step of polishing the first main surface (S45: Fig. 3) is performed Specifically, for example by chemical mechanical polishing using an abrasive material such as colloidal silica, first main surface 80b of silicon carbide substrate 80 is polished, and first main surface 80b is planarized. It should be noted that the step of polishing the first main surface may be performed after the step of forming an epitaxial layer (S50: Fig. 3) described later. Further, first main surface 80b and second main surface 80a may be polished simultaneously.

Next, the step of forming an epitaxial layer (S50: Fig. 3) is performed Specifically, referring to Fig. 7, n type drift region 81 made of silicon carbide is formed on second main surface 80a of silicon carbide substrate 80 made of silicon carbide. Formation of n type drift region 81 can be performed, for example, by a CVD (Chemical Vapor Deposition) method. For example, nitrogen (N) or phosphorus (P) is introduced as an impurity into n type drift region 81. P type base region 82 and n type region 83 are to be formed on n type drift region 81.

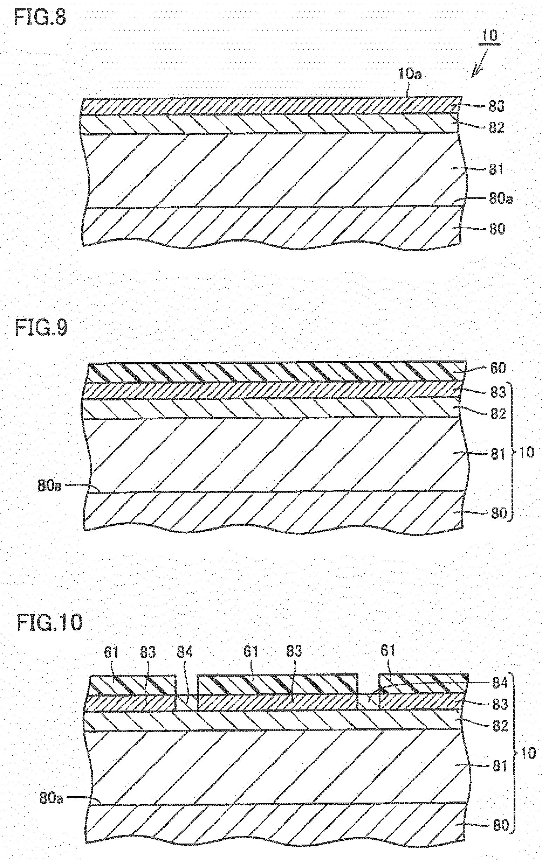

Next, the step of implanting ions (S60: Fig. 3) is performed. Referring to Fig 8, the step of implanting ions can be performed, for example, by performing ion implantation on the entire surface of n type drift region 81. For forming p type base region 82, ions of an impurity for imparting p type, for example such as aluminum (Al), are implanted into front surface 10a of n type drift region 81. Further, in the ion implantation for forming n type region 83, ions of an impurity for imparting n type, for example such as phosphorus (P), are implanted. It should be noted that, instead of ion implantation, epitaxial growth accompanied by addition of impurities may be used.

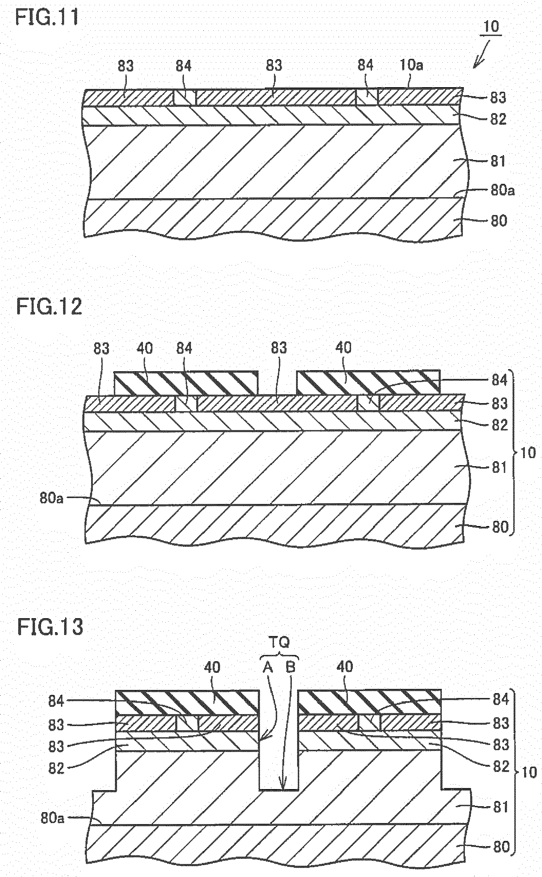

Referring to Fig. 9, a resist film 60 is formed on n type region 83 of silicon carbide substrate 10. Next, exposure and development are performed on resist film 60. Thereby, a mask layer 61 (Fig. 10) having an opening corresponding to a position where p type contact region 84 is to be formed is formed Next, p type contact region 84 is formed by ion implantation using mask layer 61. Next, mask layer 61 is removed (Fig. 11). Thus, p type contact region 84 which connects front surface 10a of silicon carbide substrate 10 and p type base region 82 is formed by a photolithography method.

Next, heat treatment is performed to activate the impurities. This heat treatment is preferably performed at a temperature of more than or equal to 1500°C and less than or equal to 1900°C, and is performed at approximately 1700°C, for example. The heat treatment is performed for approximately 30 minutes, for example. The atmosphere for the heat treatment is preferably an inert gas atmosphere, and is an Ar atmosphere, for example

Referring to Fig 12, a mask layer 40 having an opening is formed on a surface made of n type region 83 and p type contact region 84, by the photolithography method As mask layer 40, for example, a silicon oxide film or the like can be used. The opening is formed corresponding to a position where trench TR (Fig. 1) is to be formed.

Next, the step of forming a recessed portion is performed. Specifically, referring to Fig. 13, a recessed portion TQ is formed in front surface 10a of silicon carbide substrate 10, by performing plasma etching on silicon carbide substrate 10 having mask layer 40 formed thereon. Recessed portion TQ is formed by removing n type region 83, p type base region 82, and a portion of n type drift region 81 of silicon carbide substrate 10 by etching, through the opening in mask layer 40. As a method for the etching, for example, dry etching, and more specifically, inductively-coupled-plasma reactive ion etching (ICP-RIE) can be used. By performing ICP-RIE on front surface 10a of silicon carbide substrate 10 using SF₆ or a mixed gas of SF₆ and O₂ as a reactive gas, for example, recessed portion TQ having a wall surface A substantially along a thickness direction of silicon carbide substrate 10 (a vertical direction in the drawing) as well as a bottom portion B is formed in a region where trench TR (Fig. 1) is to be formed.

Next, a thermal etching step is performed. Specifically, thermal etching is performed on recessed portion TQ formed in silicon carbide substrate 10. In the thermal etching step, wall surface A of recessed portion TQ in silicon carbide substrate 10 is thermally etched within a furnace, while supplying a gas containing chlorine into the furnace. Silicon carbide substrate 10 is heated within the furnace, for example at more than or equal to 1000°C and less than or equal to 1800°C for approximately 20 minutes, and thereby wall surface A of recessed portion TQ in silicon carbide substrate 10 is etched. The temperature for the thermal etching of silicon carbide substrate 10 is preferably more than or equal to 800°C, more preferably more than or equal to 1300°C, and further preferably more than or equal to 1500°C. It should be noted that mask layer 40 made from silicon dioxide is not substantially etched during thermal etching of silicon carbide, because it has an extremely high selectivity with respect to silicon carbide.

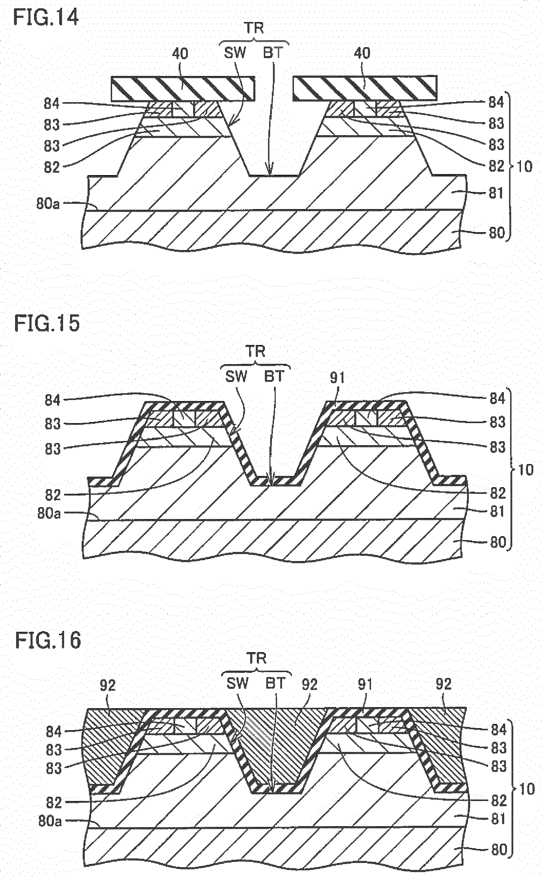

By performing the thermal etching step described above, wall surface A and bottom portion B of recessed portion TQ are etched by approximately more than or equal to 2 nm and 0.1 µm, for example, and thereby trench TR formed of wall surface SW and bottom portion BT is formed on silicon carbide substrate 10, as shown in Fig 14. Next, mask layer 40 is removed by any method such as etching. Trench TR is formed of wall surface SW serving as a side surface, and bottom portion BT connected with wall surface SW. Bottom portion BT may be a surface, or may be a line. When bottom portion BT is a line, trench TR has a V shape when viewed in a cross section.

Next, the step of forming a gate insulating film is performed. Specifically, referring to Fig. 15, after trench TR is formed by thermally etching wall surface A of recessed portion TQ described above, gate insulating film 91 is formed in contact with wall surface SW of trench TR. Gate insulating film 91, which further covers each of wall surface SW and bottom portion BT of trench TR and is in contact with n type drift region 81, p type base region 82, n type region 83, and p type contact region 84, is formed. Gate insulating film 91 is made of silicon dioxide, and can be formed, for example, by thermal oxidation.

After gate insulating film 91 is formed, NO annealing using nitric oxide (NO) as an atmospheric gas may be performed. Specifically, for example, silicon carbide substrate 10 having gate insulating film 91 formed thereon is held in a nitric oxide atmosphere, at a temperature of more than or equal to 1100°C and less than or equal to 1300°C, for approximately one hour. Thereby, nitrogen atoms are introduced into an interface region between gate insulating film 91 and p type base region 82 As a result, formation of an interface state in the interface region is suppressed, and thus channel mobility can be improved. It should be noted that a gas other than NO gas may be used as an atmospheric gas, if the gas allows such introduction of nitrogen atoms.

After the NO annealing, Ar annealing using argon (Ar) as an atmospheric gas may be further performed. Preferably, the heating temperature for the Ar annealing is higher than the heating temperature for the NO annealing, and is lower than the melting point of gate insulating film 91. This heating temperature is held for approximately one hour, for example. Thereby, formation of the interface state in the interface region between gate insulating film 91 and p type base region 82 is further suppressed. It should be noted that, as an atmospheric gas, other inert gas such as nitrogen gas may be used instead of Ar gas.

Next, the step of forming a front surface electrode (S70: Fig. 3) is performed. In the step of forming a front surface electrode, gate electrode 92 and source electrode 94 are formed. Specifically, referring to Fig. 16, gate electrode 92 is formed on gate insulating film 91. Specifically, gate electrode 92 is formed on gate insulating film 91 to fill a region inside trench TR, with gate insulating film 91 interposed therebetween. Gate electrode 92 can be formed, for example, by formation of a film of a conductor or doped polysilicon and CMP.

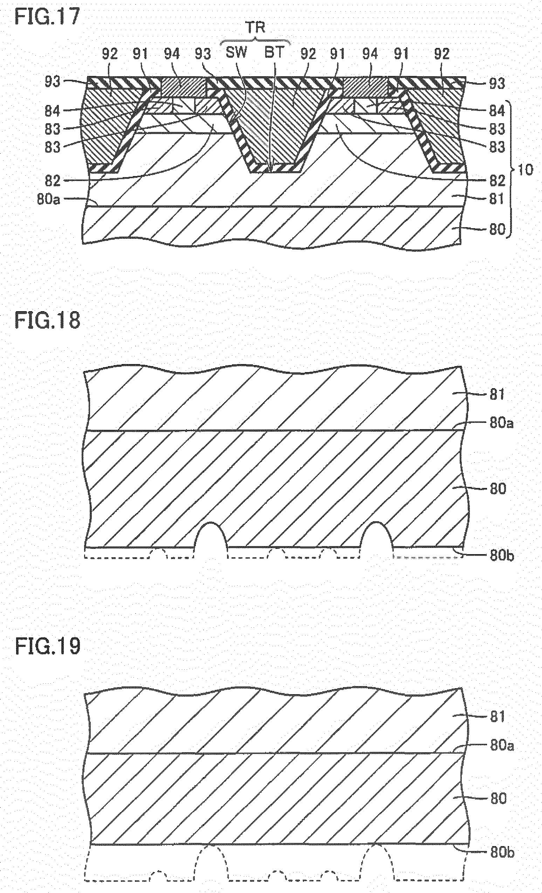

Next, referring to Fig. 17, interlayer insulating film 93 is formed on gate electrode 92 and gate insulating film 91 to cover an exposed surface of gate electrode 92 Etching is performed such that an opening is formed in interlayer insulating film 93 and gate insulating film 91. Through this opening, each of n type region 83 and p type contact region 84 is exposed on front surface 10a. Next, source electrode 94 which is in contact with each of n type region 83 and p type contact region 84 on front surface 10a is formed. Specifically, a metal film containing Ti, Al, and Si, for example, is formed in contact with each of n type region 83 and p type contact region 84, by sputtering. Next, by heating silicon carbide substrate 10 having the metal film formed thereon, the metal film is alloyed, and thus source electrode 94 which is in ohmic contact with silicon carbide substrate 10 is formed.

Next, the step of grinding the first main surface (S80: Fig. 3) is performed. Specifically, by grinding first main surface 80b of silicon carbide substrate 80, silicon carbide substrate 80 is removed by approximately 200 µm, for example. In the step of grinding first main surface 80b, preferably at least portions of etch pits 3 are removed. Referring to Fig. 18, first main surface 80b may be ground such that portions of etch pits 3a of micropipes are left and etch pits 3b other than micropipes are all removed. A region having etch pit 3b of a micropipe is a chip region which will be determined as defective by the step of performing screening of chips described later, and will be discarded. Accordingly, a portion of etch pit 3a of a micropipe may be left. On the other hand, etch pit 3b other than a micropipe is a chip region which will be determined as conforming by the step of performing screening of chips described later. Accordingly, by removing etch pits 3b other than micropipes, defect density in first main surface 80b can be reduced.

Both etch pits 3a of micropipes and etch pits 3b other than micropipes may be removed, as shown in Fig. 19. If etch pits 3a of micropipes are left even partially, when back surface electrode 98 is formed on first main surface 80b in the step of forming a back surface electrode (S90: Fig. 3) described later, back surface electrode 98 is formed such that it also enters the inside of etch pits 3a of micropipes. Accordingly, a front surface of back surface electrode 98 has large unevenness. When the front surface of back surface electrode 98 in the chip region which will be determined as defective in the step of performing screening of chips (S110: Fig. 3) described later has large unevenness, the front surface of back surface electrode 98 in the chip region which will be determined as conforming also has large unevenness By removing etch pits 3a of micropipes as shown in Fig. 19, planarization of first main surface 80b can be improved Accordingly, planarization of back surface electrode 98 formed on first main surface 80b is improved

Next, the step of forming a back surface electrode (S90: Fig. 3) is performed. Specifically, back surface electrode 98 is formed on first main surface 80b of silicon carbide substrate 80. The material used for back surface electrode 98 may be the same as the material for the source electrode described above.

Next, the step of cutting the silicon carbide substrate (S100: Fig. 3) is performed. Referring to Fig. 21, silicon carbide substrate 80 is cut, for example, with a dicing saw, to form the plurality of chips C12 to C65. That is, silicon carbide substrate 10 is cut into the plurality of chips C12 to C65. The plurality of chips C12 to C65 include chips C25 and C43 each having etch pit 3a of a micropipe, and chips C23, C32, and C55 each having etch pit 3b other than a micropipe.

Next, the step of performing screening of the chips (S110: Fig. 3) is performed. In the step of performing screening of the chips, screening of the chips is performed based on the two-dimensional positional information on the micropipes obtained in the step of obtaining positional information on the micropipes (S30: Fig. 3). The step of performing screening of the chips has the step of associating the two-dimensional positional information on etch pits 3a of micropipes with identification numbers of the chips. For example, it is determined in which cut chip having which identification number the position of the center of etch pit 3a of a micropipe is located. Referring to Fig. 20, for example, it is determined in which region of first main surface 80b the position of the center of etch pit 3a of a micropipe is located. It is determined with which chip having which identification number a region of silicon carbide substrate 10 located from x₃ to x₄ in the x direction and from y₃ to y₄ in the y direction is associated, after silicon carbide substrate 80 is cut. When the position of the center of etch pit 3a of a micropipe is (x₁, y₁), the chip including that etch pit 3a is determined as chip C25 Similarly, when the position of the center of etch pit 3a of a micropipe is (x₂, y₂), the chip including that etch pit 3a is determined as chip C43. In the step of performing screening of the chips, a chip including etch pit 3a of a micropipe is determined as a defective product, and a chip not including etch pit 3a of a micropipe is determined as a conforming product.

Next, the function and effect of the method for manufacturing MOSFET 1 in accordance with the first embodiment will be described.

According to MOSFET 1 in accordance with the first embodiment, the two-dimensional positional information on etch pits 3a of micropipes in first main surface 80b is obtained, and screening of the chips is performed based on the two-dimensional positional information. Accordingly, no matter where a micropipe is present in first main surface 80b of silicon carbide substrate 80, a chip including the micropipe can be detected. As a result, chips including micropipes can be screened out with high accuracy.

Further, according to the method for manufacturing MOSFET 1 in accordance with the first embodiment, silicon carbide epitaxial layer 81 is formed in contact with second main surface 80a. Thereby, even if a micropipe is covered with silicon carbide epitaxial layer 81 and becomes a blocked micropipe, a chip including the micropipe can be screened out with high accuracy.

Furthermore, according to the method for manufacturing MOSFET 1 in accordance with the first embodiment, the two-dimensional positional information is associated with identification numbers of chips C12 to C65. Thereby, a chip in which a micropipe is present can be specified.

Furthermore, according to the method for manufacturing MOSFET 1 in accordance with the first embodiment, first main surface 80b is polished after the step of causing etch pits 3 including the micropipes to appear. Thereby, warpage of silicon carbide substrate 80 generated in the step of causing the etch pits to appear can be reduced. Further, when first main surface 80b is polished after the step of forming silicon carbide epitaxial layer 81 in contact with second main surface 80a, both warpage of silicon carbide substrate 80 generated by the step of forming silicon carbide epitaxial layer 81 and warpage of silicon carbide substrate 80 generated in the step of causing the etch pits to appear can be reduced

Furthermore, according to the method for manufacturing MOSFET 1 in accordance with the first embodiment, first main surface 80b is ground to remove at least portions of etch pits 3. By removing small etch pits 3b other than etch pits 3a of micropipes, defects in a conforming chip can be removed. Further, when etch pits 3a of micropipes are also removed, first main surface 80b has small unevenness. Thus, planarization of electrode 98 formed in contact with first main surface 80b can be improved. As a result, planarization of electrode 98 in a conforming chip can be improved.

Furthermore, according to the method for manufacturing MOSFET 1 in accordance with the first embodiment, back surface electrode 98 is formed in contact with first main surface 80b after the step of grinding first main surface 80b. Thereby, adhesion of back surface electrode 98 to first main surface 80b can be improved.

### (Second Embodiment)

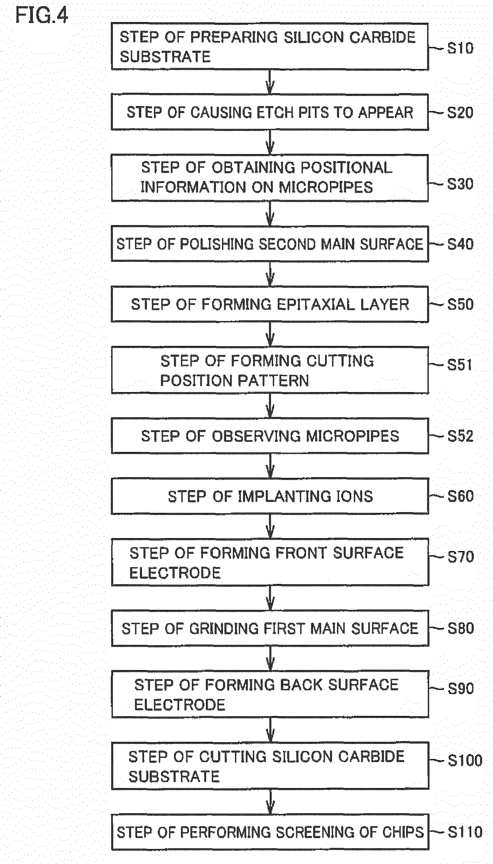

Next, a method for manufacturing MOSFET 1 in accordance with a second embodiment will be described with reference to Fig. 4. It should be noted that MOSFET 1 manufactured by the manufacturing method in accordance with the second embodiment has the same structure as that in the first embodiment.

First, the step of preparing a silicon carbide substrate (S10: Fig. 4) is performed, by the same method as that described in the first embodiment. Thereby, the silicon carbide substrate having first main surface 80b and second main surface 80a opposite to first main surface 80b is prepared. Next, the step of causing etch pits to appear (S20: Fig 4) is performed, by the same method as that described in the first embodiment. Thereby, etch pits 3 including etch pits 3a of micropipes appear in first main surface 80b. Next, the step of obtaining positional information on the micropipes (S30: Fig. 4) is performed, by the same method as that described in the first embodiment. Thereby, two-dimensional positional information on etch pits 3a of micropipes in first main surface 80b of silicon carbide substrate 80 is obtained. Next, the step of polishing the second main surface (S40: Fig 4) is performed, by the same method as that described in the first embodiment. Thereby, second main surface 80a of silicon carbide substrate 80 is polished. Next, the step of forming an epitaxial layer (S50: Fig. 4) is performed, by the same method as that described in the first embodiment. Thereby, silicon carbide epitaxial layer 81 is formed in contact with second main surface 80a of silicon carbide substrate 80.

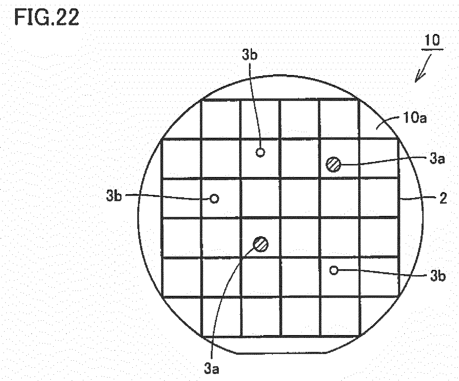

Next, the step of forming a cutting position pattern (S51: Fig. 4) is performed. Specifically, referring to Fig. 22, pattern 2 indicating a cutting position where the silicon carbide substrate is to be cut in the step of cutting the silicon carbide substrate (S100: Fig. 4) described later is formed on front surface 10a of silicon carbide epitaxial layer 81 formed on silicon carbide substrate 80. The pattern indicating the cutting position is formed by providing grooves having a linear pattern, for example, in front surface 10a of silicon carbide epitaxial layer 81, for example. Pattern 2 is provided corresponding to the shape of cut chips, and may be the one in which, for example, a plurality of rectangular or square frames are arranged along the x axis direction and the y axis direction, when viewed from the direction of a normal to front surface 10a of silicon carbide epitaxial layer 81. Thereby, outer edges of the cut chips can be clarified.

Next, the step of observing the micropipes (S52: Fig. 4) is performed. For example, an optical microscope is placed at a position facing second main surface 80a of silicon carbide substrate 80. Next, for example, the optical microscope is focused on first main surface 80b, and an image of entire first main surface 80b is obtained by the optical microscope. Thereby, two-dimensional information on first main surface 80b is obtained. The two-dimensional information on first main surface 80b includes the two-dimensional positional information on etch pits 3a of micropipes in first main surface 80b. Two-dimensional positions, in first main surface 80b, of etch pits 3a of micropipes formed in first main surface 80b are specified, for example, based on the image of first main surface 80b obtained by the optical microscope. Thereafter, for example, the optical microscope is focused on second main surface 80a, and an image of entire second main surface 80a is obtained. The two-dimensional positional information on etch pits 3a of micropipes in the first main surface is compared with pattern 2 indicating the cutting position formed on second main surface 80a. It is specified where etch pits 3a of micropipes are present in pattern 2 indicating the cutting position. Information on identification numbers (addresses) of chips each including etch pit 3a of a micropipe is recorded in an external memory or the like. It should be noted that the micropipes may be specified by the same method as that described in the step of obtaining positional information on the micropipes (S30: Fig. 3).

Next, the step of implanting ions (S60: Fig. 4), the step of forming a front surface electrode (S70: Fig. 4), the step of grinding the first main surface (S80: Fig 4), and the step of forming a back surface electrode (S90: Fig. 4) are performed by the same methods as those described in the first embodiment

Next, the step of cutting the silicon carbide substrate (S100: Fig. 4) is performed. Specifically, silicon carbide substrate 80 is cut along pattern 2 indicating the cutting position formed by the step of forming the cutting position pattern (S51: Fig. 4) on front surface 10a of silicon carbide epitaxial layer 81 formed on silicon carbide substrate 80. Thereby, silicon carbide substrate 10 is cut into the plurality of chips C12 to C65, as shown in Fig. 21. The plurality of chips C12 to C65 include chips C25 and C43 each having etch pit 3a of a micropipe, and chips C23, C32, and C55 each having etch pit 3b other than a micropipe.

Next, the step of performing screening of the chips (S110: Fig. 4) is performed. Based on the information on the identification numbers (addresses) of the chips each including etch pit 3a of a micropipe recorded in the step of observing the micropipes (S52: Fig. 4), a chip including etch pit 3a of a micropipe is determined as a defective product, and a chip not including etch pit 3a of a micropipe is determined as a conforming product. It should be noted that the identification numbers of the chips each including etch pit 3a of a micropipe specified as described above is information obtained in the step of observing the micropipes based on the two-dimensional positional information on etch pits 3a of micropipes in the first main surface. It should be noted that screening of the chips may be performed based on the two-dimensional positional information on the micropipes obtained in the step of obtaining positional information on the micropipes (S30: Fig. 4), or based on information determined from both the information obtained in the step of observing the micropipes (S52: Fig. 4) and the information obtained in the step of obtaining positional information on the micropipes (S30: Fig. 4).

Next, the function and effect of the method for manufacturing MOSFET 1 in accordance with the second embodiment will be described.

According to the method for manufacturing MOSFET 1 in accordance with the second embodiment, pattern 2 indicating the cutting position for chips C12 to C65 is formed on front surface 10a of silicon carbide epitaxial layer 81. In the step of cutting silicon carbide substrate 80 into the plurality of chips C12 to C65, silicon carbide substrate 80 is cut along pattern 2. By forming the pattern indicating the cutting position, a chip in which a micropipe is present can be specified by a simple method.

Further, according to the method for manufacturing MOSFET 1 in accordance with the second embodiment, the step of performing screening of chips C12 to C65 is performed by comparing the two-dimensional positional information on the micropipes with the position of pattern 2. In a case where silicon carbide substrate 80 has small warpage, a chip in which a micropipe is present can be specified by a simple method and with high accuracy, by comparing the two-dimensional positional information on the micropipes in first main surface 80b with the position of pattern 2 formed on front surface 10a, which is on a side closer to second main surface 80a.

It should be noted that, although the first conductivity type has been described as n type and the second conductivity type has been described as p type in each of the embodiments described above, the first conductivity type may be p type and the second conductivity type may be n type. Further, although an MOSFET has been described as an example of the silicon carbide semiconductor device in each of the embodiments described above, the silicon carbide semiconductor device may be an IGBT (Insulated Gate Bipolar Transistor), an SBD (Schottky Barrier Diode), or the like.

It should be understood that the embodiments disclosed herein are illustrative and non-restrictive in every respect. The scope of the present invention is defined by the scope of the claims, rather than the description above, and is intended to include any modifications within the scope and meaning equivalent to the scope of the claims.

### REFERENCE SIGNS LIST

1: silicon carbide semiconductor device (MOSFET); 2: pattern; 3, 3a, 3b: etch pit, 10, 80: silicon carbide substrate; 10a: front surface; 40, 61: mask layer; 60: resist film, 80a: second main surface; 80b: first main surface; 80c: orientation flat; 81: silicon carbide epitaxial layer (n type drift region); 82: p type base region; 83: n type region; 84: p type contact region; 91: gate insulating film; 92: gate electrode; 93: interlayer insulating film; 94: source electrode; 95: source interconnection layer; 98: back surface electrode (drain electrode); A, SW: wall surface; B, BT: bottom portion; C12 to C65, C23, C25, C43: chip; TQ: recessed portion; TR: trench.

## Claims

1. A method for manufacturing a silicon carbide semiconductor device, comprising steps of:
preparing a silicon carbide substrate having a first main surface and a second main surface opposite to said first main surface;
causing etch pits including etch pits of micropipes to appear in said first main surface by etching said first main surface;
obtaining two-dimensional positional information on said micropipes in said first main surface;
cutting said silicon carbide substrate into a plurality of chips; and
performing screening of said chips based on said two-dimensional positional information,
wherein said first main surface is a silicon plane or a plane having an off angle of less than or equal to 10° relative to said silicon plane.

2. The method for manufacturing the silicon carbide semiconductor device according to claim 1, further comprising the step of forming a silicon carbide epitaxial layer in contact with said second main surface.

3. The method for manufacturing the silicon carbide semiconductor device according to claim 2, further comprising the step of forming a pattern indicating a cutting position for said chips on a front surface of said silicon carbide epitaxial layer,
wherein, in the step of cutting said silicon carbide substrate into said plurality of chips, said silicon carbide substrate is cut along said pattern.

4. The method for manufacturing the silicon carbide semiconductor device according to claim 3, wherein the step of performing screening of said chips is performed by comparing said two-dimensional positional information on said micropipes with a position of said pattern.

5. The method for manufacturing the silicon carbide semiconductor device according to claim 1 or 2, further comprising the step of associating said two-dimensional positional information with identification numbers of said chips.

6. The method for manufacturing the silicon carbide semiconductor device according to claim 5, further comprising the step of polishing said first main surface after the step of causing said etch pits including said micropipes to appear.

7. The method for manufacturing the silicon carbide semiconductor device according to any one of claims 1 to 6, further comprising the step of grinding said first main surface to remove at least portions of said etch pits.

8. The method for manufacturing the silicon carbide semiconductor device according to claim 7, further comprising the step of forming an electrode in contact with said first main surface after the step of grinding said first main surface.
